# FASCICULE DE BREVET EUROPEEN

(11) **EP 4 033 531 B1**
(45) Date de publication et mention de la délivrance du brevet: **02.08.2023**
(21) Numéro de dépôt: 22161925.7
(22) Date de dépôt: 14.03.2018
(51) Int. Cl.: H01L 25/075, H01L 21/02, H01L 33/00, H01L 33/02

(54) **PROCÉDÉ DE FABRICATION D'UNE PLURALITÉ D'ÎLOTS SEMICONDUCTEURS CRISTALLINS**
VERFAHREN ZUR HERSTELLUNG EINER VIELZAHL VON KRISTALLINEN HALBLEITENDEN INSELN
METHOD FOR MANUFACTURING A PLURALITY OF CRYSTALLINE SEMICONDUCTOR ISLANDS

(30) Priorité: 17.03.2017 FR 1752230; 13.03.2018 FR 1852155; 13.03.2018 FR 1852156
(43) Date de publication de la demande: 27.07.2022
(62) Demande divisionnaire de: 18714309.4
(73) Titulaire: SOITEC, 38190 Bernin (FR)
(72) Inventeur: SOTTA, David, 38100 GRENOBLE (FR); LEDOUX, Olivier, 38100 GRENOBLE (FR); BONNIN, Olivier, 38320 BRESSON (FR); BETHOUX, Jean-Marc, 38500 LA BUISSE (FR); LOGIOU, Morgane, 38920 CROLLES (FR); CAULMILONE, Raphaël, 38660 SAINT PANCRASSE (FR)
(74) Mandataire: IP Trust

(56) Documents cités:
- EP-A1- 2 151 852
- EP-A1- 2 151 856
- US-A1- 2009 045 394
- SEKIGUCHI HIROTO ET AL: "Emission color control from blue to red with nanocolumn diameter of InGaN/GaN nanocolumn arrays grown on same substrate", APPLIED PHYSICS LETTERS, A I P PUBLISHING LLC, US, vol. 96, no. 23, 7 juin 2010 (2010-06-07), pages 231104-231104, XP012131471, ISSN: 0003-6951, DOI: 10.1063/1.3443734
- SHIODA T ET AL: "Selective Area Metal-Organic Vapor Phase Epitaxy of Nitride Semiconductors for Multicolor Emission", IEEE JOURNAL OF SELECTED TOPICS IN QUANTUM ELECTRONICS, IEEE SERVICE CENTER, PISCATAWAY, NJ, US, vol. 15, no. 4, 14 juillet 2009 (2009-07-14), pages 1053-1065, XP011344263, ISSN: 1077-260X, DOI: 10.1109/JSTQE.2009.2015433

## Description

### DOMAINE DE L'INVENTION

La présente invention concerne un procédé d'utilisation d'un substrat de croissance pour fabriquer collectivement une pluralité de dispositifs optoélectroniques comportant des couches actives de compositions différentes. L'invention trouve une application toute particulière dans le domaine des micro-écrans d'affichage.

### ARRIERE PLAN TECHNOLOGIQUE DE L'INVENTION

Les documents EP2151852 et EP2151856 divulguent une technologie prévoyant de former, sur un substrat, des îlots de matériau semi-conducteur cristallin relaxés ou partiellement relaxés. Ces îlots peuvent servir à la fabrication collective de diodes électroluminescentes (DELs), comme cela est par exemple détaillé dans le document EP2865021.

Le document US2009045394 propose de fournir une couche contrainte d'AlGaN et d'y former des motifs pour, selon ce document, relaxer une partie superficielle de cette couche de manière différenciée.

De multiples produits combinent des DELs émettant à des longueurs d'onde différentes pour former un point lumineux coloré. C'est le cas notamment des écrans d'affichage permettant de former une image composée de pixels, chaque pixel associant une DEL rouge, verte et bleu, dont on peut contrôler individuellement l'émission afin de former, par combinaison des émissions lumineuses, un point lumineux de couleur choisie.

Les DELs qui sont associées pour former le pixel ne sont généralement pas fabriquées à partir des mêmes matériaux et des mêmes technologies. Ainsi, les DELs bleues ou vertes peuvent être formées à partir de nitrure (de formule générale InGaN), et les DELs rouges à partir de phosphure (de formule générale AlGaInP) . La fabrication d'un écran met en oeuvre l'assemblage, une à une, des diodes pour former les pixels du dispositif final, par exemple par une technique d'insertion de composants (« Pick and Place » selon la terminologie anglo-saxonne) .

Les matériaux n'ayant pas les mêmes propriétés, les caractéristiques de vieillissement, de comportement thermique, électrique et/ou d'efficacité des dispositifs qui les exploitent sont généralement bien différentes. Ces variabilités doivent être prises en compte lors de la conception d'un produit intégrant des DELs formées à base de matériaux différents, ce qui rend cette conception parfois complexe.

D'autres solutions prévoient de former les pixels à partir de diodes toutes identiques, fabriquées sur un même substrat et/ou à l'aide de la même technologie. On peut alors réaliser des micro panneaux monolithiques de DELs, présentant une dimension réduite, et une résolution importante. A titre d'exemple d'une telle réalisation, on pourra se référer au document « 360 PPI Flip-Chip Mounted Active Matrix Adressable Light Emitting Diode on Silicon (LEDoS) Micro-Displays », Zhao Jun Liu et Al, Journal of Display Technologie, April 2013. Le rayonnement lumineux émis par les DELs du micro panneau peut être choisi dans le domaine de l'ultraviolet et sélectivement converti, d'une diode à l'autre, dans différentes longueurs d'onde pour correspondre à des émissions lumineuses rouges, vertes et bleues de manière à former un écran couleur. Cette conversion peut être obtenue en disposant une matière phosphorescente sur la face d'émission des DELs. La conversion est toutefois consommatrice d'énergie lumineuse, ce qui réduit la quantité de lumière émise par chaque pixel et donc l'efficacité du dispositif d'affichage. Elle nécessite également de dispenser les matières phosphorescentes sur les surfaces d'émission des DELs ce qui complexifie le procédé de fabrication de ces micro panneaux. De plus, la taille des grains de matière phosphorescente peut excéder la dimension souhaitée des pixels lumineux, ce qui ne permet pas toujours d'employer cette solution.

On connaît également de l'état de la technique les documents :
- « Emission color control from blue to red with nanocolumn diameter of InGaN/GaN nanocolumn arrays grown on same substrate », applied physics letters, vol 96, n°23 , 7 juin 2010 ;
- "Sélective Area Métal Organic Vapor Phase Epitaxy of Nitride Semiconductors for multicolor Emission", IEEE journal of selected topics in quantum electronics, vol 15, n°4, 1er juillet 2009.

Afin de parer aux limitations qui viennent d'être exposées, il serait souhaitable de pouvoir fabriquer simultanément sur un même substrat, à partir d'une même technologie, des DELs pouvant émettre dans des longueurs d'onde différentes. D'une manière plus générale, il serait avantageux de fabriquer collectivement des dispositifs ayant des propriétés optoélectroniques pouvant être différentes les unes des autres.

### BREVE DESCRIPTION DE L'INVENTION

L'invention propose un procédé d'utilisation d'un substrat de croissance selon la revendication 1
- D'autres caractéristiques avantageuses et non limitatives de cette utilisation sont définies par les revendications dépendantes

### BREVE DESCRIPTION DES DESSINS

D'autres caractéristiques et avantages de l'invention ressortiront de la description détaillée de l'invention qui va suivre en référence aux figures annexées sur lesquels :
- les figures 1a, 1b et 1c représentent schématiquement des coupes et une vue de dessus de substrats de croissance;
- les figures 2a, 2b et 2c représentent un exemple de disposition et de répartition d'îlots semi-conducteurs cristallins à la surface d'un support de croissance ;
- Les figures 3a à 3e représentent un premier procédé de fabrication d'un substrat de croissance ;
- Les figures 4a à 4c représentent un deuxième procédé de fabrication d'un substrat de croissance ;
- Les figures 5a à 5d représentent un procédé de réalisation d'une couche de fluage comprenant des pavés de viscosité différents ;
- Les figures 6a à 6m représentent un troisième procédé de fabrication d'un substrat de croissance.

### DESCRIPTION DETAILLEE DE L'INVENTION

### Substrat de croissance

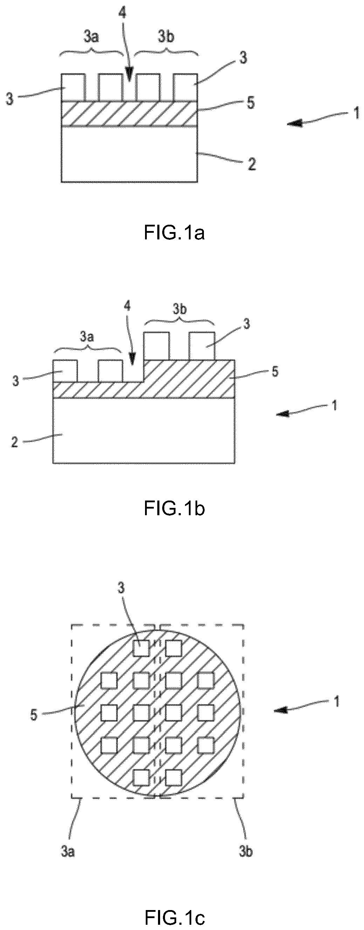

Selon un premier aspect, la présente description porte sur un substrat de croissance 1 pour la formation de dispositifs optoélectroniques. Les figures 1a et 1b représentent schématiquement une coupe de deux substrats de croissance. La figure 1c représente une vue de dessus de ces substrats. Le substrat de croissance 1 est destiné à être placé dans un équipement de dépôt, tel qu'un bâti d'épitaxie, afin de former à la surface exposée du substrat 1 des couches actives de composants optoélectroniques. Ce substrat 1 peut également servir de support mécanique permettant la manipulation des dispositifs au cours des étapes complémentaires de fabrication (formation des contacts électriques, isolation des dispositifs entre eux, etc.) conduisant à disposer d'un dispositif fonctionnel.

Le substrat de croissance 1 comprend un support de croissance 2. Il peut s'agir d'une plaquette circulaire de matériaux, par exemple en silicium ou en saphir, de dimension normalisée, par exemple de 2 pouces (50 mm), 4 pouces (100 mm) voire 200 mm de diamètre. Mais le substrat de croissance 1 n'est nullement limitée à ces dimensions ou à cette forme.

D'une manière générale, la nature du support de croissance 2 est choisie pour être apte à résister aux traitements (tels que les dépôts, les traitements thermiques, etc.) mis en oeuvre lors de la fabrication du substrat de croissance 1 lui-même et lors de la fabrication des dispositifs optoélectroniques. Avantageusement, le support de croissance 2 présente un coefficient d'expansion thermique similaire ou proche de celui des matériaux qui formeront la couche utile du dispositif optoélectronique, afin de limiter les contraintes importantes qui pourraient endommager ces dispositifs à l'issue de leur fabrication.

Le substrat de croissance 1 comprend également, disposée sur le support de croissance 2, une pluralité d'îlots semi-conducteurs cristallins 3 (et désigné plus simplement par le terme « îlot(s) » dans la suite de cette description). Chaque îlot 3 est destiné à recevoir les couches actives d'un dispositif optoélectronique, tel qu'une DEL, un laser ou une cellule photovoltaïque. A cet effet les îlots 3 peuvent être en matériaux III-N. Ainsi, pour la formation de DELs à base de nitrure, les îlots 3 peuvent être constitués de GaN ou d'InGaN de structure wurtzite, dont l'axe c est perpendiculaire à la surface, et dans laquelle la proportion d'indium peut varier entre 0% et 20%, et en particulier entre 1,5% et 8%.

Par « îlot » on désigne un bloc de matériau entièrement séparé des autres îlots disposés sur le support de croissance 2. Et par « cristallin » on signifie que les atomes constituants un îlot 3 sont assemblés de manière ordonnée pour former un bloc de matériau monocristallin, ce bloc pouvant néanmoins comprendre des défauts d'arrangement du type dislocation, plan de glissement ou défaut ponctuel.

Les îlots 3 sont séparés les uns des autres par l'intermédiaire de tranchées 4. Ces tranchées peuvent présenter une dimension latérale, séparant deux îlots 3, comprise entre 0,1 et 50 microns, ou 1 et 50 microns et typiquement de l'ordre de 2 microns ou de 20 microns. Chaque îlot présente une dimension relativement réduite vis-à-vis du substrat de croissance, qui peut s'étendre, dans sa dimension la plus grande, par exemple entre 1 micron à 1 mm, selon l'application finale visée. La surface des îlots 3 peut être comprise entre 1µm² ou 4µm² et 1mm², et préférentiellement entre 25 µm² et 400µm². Chaque îlot 3 peut présenter une forme quelconque, en vue de dessus, par exemple circulaire, carrée, triangulaire, hexagonale ou rectangulaire. Son épaisseur est typiquement inférieure à 200nm, notamment lorsqu'il est constitué d'InGaN. Les îlots 3 peuvent être tous de formes et dimensions identiques ou différentes.

Les îlots 3 ne présentent pas tous le même paramètre de maille. Ainsi, un premier groupe d'îlots 3a présente un premier paramètre de maille, et un deuxième groupe d'îlots 3b présente un deuxième paramètre de maille, différent du premier.
Dans la variante du support de croissance 1 représenté sur la figure 1a, et comme cela sera rendu apparent lors de la description du procédé de fabrication de ce substrat, tous les îlots 3 sont constitués du même matériau. Les matériaux des îlots 3 étant identiques entre eux, l'existence d'une différence de paramètres de maille dénote l'existence d'un état de contrainte différent entre les îlots 3 constituant les deux groupes 3a, 3b.

Dans la variante du support de croissance 1 représenté sur la figure 1b, les matériaux des îlots 3 ne sont pas identiques entre eux d'un groupe à l'autre. Par ailleurs, l'état de contraintes des îlots 3 constituant les deux groupes 3a, 3b peuvent également être différent d'un groupe à l'autre. En conséquence, les deux groupes d'îlots 3a, 3b présentent des paramètres de maille différents.

La variété de paramètres de maille des îlots 3 du substrat de croissance 1 sera mise à profit pour fabriquer collectivement des dispositifs optoélectroniques présentant des propriétés lumineuses distincts, à l'aide d'une unique technologie de fabrication et sur un unique substrat de croissance.

À titre d'exemple, on pourra former sur le premier groupe d'îlots 3a, qui présente le premier paramètre de maille, une première DEL émettant directement à une première longueur d'onde, par exemple dans le vert, et former sur le deuxième groupe d'îlots 3b, qui présente le deuxième paramètre de maille, une seconde DEL émettant directement à une seconde longueur d'onde, par exemple dans le bleu. Par l'expression « émettant directement » on signifie que cette émission correspond aux rayonnements lumineux émis par les couches actives (les puits quantiques) d'une DEL, sans nécessiter l'emploi de phosphore de conversion.

On peut prévoir également que le substrat de croissance 1 comporte au moins un troisième groupe d'îlots, ce troisième groupe présentant un troisième paramètre de maille différent du premier et du deuxième. Plus généralement, le substrat de croissance peut compter un nombre quelconque de groupe d'îlots, chaque groupe étant formé d'îlots présentant un paramètre de maille différent des îlots appartenant aux autres groupes. On pourra de la sorte disposer d'un substrat de croissance 1 permettant de former des DELs émettant dans le domaine des longueurs d'onde rouges, vertes, bleus et infrarouges sur un même substrat à l'aide d'une unique technologie.

La répartition et la disposition des groupes d'îlots 3a, 3b à la surface du support de croissance 2 n'est pas une caractéristique essentielle, et toutes les répartitions et dispositions possibles sont envisageables. Elles peuvent être parfois dictées par l'application envisagée.

On a ainsi représenté sur les figures 1a à 1c un premier exemple de répartition et de disposition des premier et deuxième groupes d'îlots 3a, 3b à la surface du support 2. Sur cet exemple, le premier groupe d'îlots 3a occupe une première zone du support 2 et le second groupe d'îlots 3b une deuxième zone du support 2, qui sont distincte l'une de l'autre et adjacente l'une à l'autre.

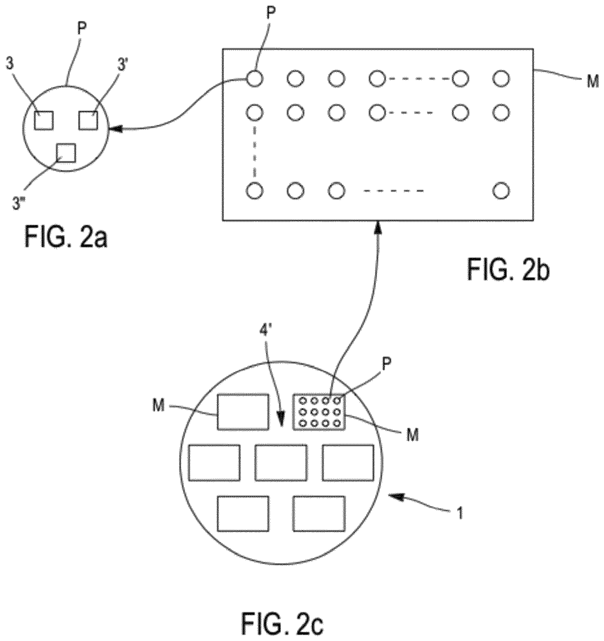

De manière avantageuse, on pourra choisir de placer côte à côte un îlot 3, 3', 3'' d'un premier, deuxième et troisième groupe d'îlots permettant de former respectivement des DELs émettant dans des couleurs différentes, par exemple respectivement rouge, verte et bleue. Cette disposition est représentée schématiquement sur la figure 2a. Une telle combinaison de DELs constitue un pixel lumineux P dont la couleur d'émission peut être contrôlée. Les îlots 3, 3', 3" qui recevront les DELs constitutives de ces pixels P peuvent être disposés de manière régulière à la surface du support de croissance 2. On peut de la sorte former des pixels P monolithiques, c'est à dire disposés sur un même substrat et manipulables en tant que pixel, par exemple par un dispositif d'insertion de composants, pour être intégrés dans un dispositif fonctionnel.

Dans le cas où l'on vise à former un micro panneau monolithique de DELs, par exemple pour un micro-écran d'affichage couleur, les pixels P pourront par exemple être régulièrement répartis selon des lignes et des colonnes pour former une matrice M, comme cela est représenté sur la figure 2b. Et un substrat de croissance 1 peut comporter une pluralité de telles matrices M, comme cela est représenté sur la figure 2c.

Revenant à la description des figures 1a et 1b, et outre le support de croissance 2 et les îlots cristallins semi-conducteurs 3, le substrat de croissance 1 comporte également au moins une couche d'assemblage 5 disposée entre le support de croissance 2 et les îlots 3. Ici, la couche d'assemblage est directement en contact avec le support de croissance et avec les îlots 3, mais le substrat de croissance pourrait comporter d'autres couches intermédiaires. Cette couche d'assemblage 5 peut comprendre un diélectrique tel qu'une couche d'oxyde de silicium ou de nitrure de silicium, ou composée d'un empilement de telles couches conçues pour, par exemple, faciliter le retrait ultérieur du support de croissance.

Dans la variante du substrat de croissance 1 représenté sur la figure 1b, la couche d'assemblage 5 ne présente pas une épaisseur uniforme. Pour des raisons qui seront rendues apparentes en relation avec la description du procédé de fabrication du substrat de croissance 1, la couche d'assemblage présente une première épaisseur au droit des îlots 3 du premier groupe d'îlots 3a, et une seconde épaisseur, différente de la première, au droit des îlots 3 du deuxième groupe d'îlots 3b. D'une manière plus générale, la couche d'assemblage 5 présente une épaisseur distincte au droit des îlots de chacun des groupes d'îlots du substrat 1.

### Procédé de fabrication d'un substrat de croissance

On expose maintenant plusieurs exemples de procédés de fabrication du substrat de croissance 1 qui vient d'être présenté.

Ces procédés mettent en oeuvre les principes de la technologie de transfert et de relaxation d'îlots semi-conducteurs cristallins, tels que ceux-ci sont par exemple décrits dans les documents EP2151852, EP2151856 ou FR2936903.

Pour rappel, selon un exemple de mise en oeuvre conforme à cette approche, on forme tout d'abord sur un substrat donneur une couche de semi-conducteur cristallin contraint. Puis, on transfère cette couche sur un substrat comportant une couche de fluage par collage et par amincissement et/ou fracture du substrat donneur. On définit ensuite des îlots dans la couche transférée, puis on traite thermiquement le substrat et les îlots à une température supérieure à la température de transition visqueuse de la couche de fluage, par exemple en BPSG, ce qui conduit à la relaxation au moins partielle des îlots. Le degré de relaxation obtenu à l'issue du traitement thermique de relaxation peut atteindre 70 à 80% ou 95% du degré de relaxation maximal correspondant à l'obtention d'une couche parfaitement relaxée. Ce degré de relaxation est dépendant de l'épaisseur des îlots, de la durée et de l'amplitude du traitement thermique.

Pour assister cette relaxation et éviter un phénomène de gauchissement des îlots au cours de la déformation plastique qui s'opère au cours de la relaxation, il peut être prévu de former une couche raidisseur sur ou sous les îlots, avant l'application du traitement thermique de relaxation. Comme cela est détaillé dans le document « Buckling suppression of SiGe islands on compliant substrates », Yin et al (2003), Journal of Applied Physics, 94(10), 6875-6882, le degré de relaxation d'un îlot obtenu après cette étape de traitement thermique est celui qui équilibre les contraintes présentes dans la couche raidisseur et dans l'îlot. On note que la couche raidisseur peut être formée (ou comprendre) d'un résidu du substrat donneur qui aurait été préservé sur la couche contrainte à l'issue de son transfert sur la couche de fluage. Elle peut avoir été placée sur la face exposée du substrat donneur pour se retrouver sous l'îlot à l'issue du transfert de la couche contrainte et de la formation des îlots.

On met à profit le phénomène de relaxation pour proposer des procédés de fabrication d'une pluralité d'îlots semi-conducteurs cristallins, présentant une variété de paramètres de maille. Plus particulièrement, ces procédés prévoient de fournir un substrat de relaxation comportant un support 7, une couche de fluage 8 disposée sur le support 7 et, disposée sur la couche de fluage, une pluralité d'îlots semi-conducteurs cristallins 9 présentant un paramètre de maille initial, une partie au moins de cette pluralité d'îlots étant des îlots contraints. Un premier groupe d'îlots 9a présente un premier potentiel d'expansion latéral et un deuxième groupe d'îlots 9b présente un deuxième potentiel d'expansion latéral, différent du premier.

Par « potentiel d'expansion latéral », on désigne l'expansion ou la contraction latérale qu'un îlot 9 doit subir pour réduire son énergie de contrainte élastique et l'équilibrer à l'énergie de retenue de la couche de fluage 8 avec laquelle il est en contact.

Les procédés prévoient également de traiter thermiquement le substrat de relaxation 6 à une température de relaxation supérieure ou égale à la température de transition vitreuse de la couche de fluage 8 pour provoquer la relaxation différenciée des îlots du premier et du second groupe, le paramètre de maille des îlots relaxés du premier groupe 3a et des îlots relaxés du second groupe 3b présentant alors des valeurs différentes

### Premier procédé

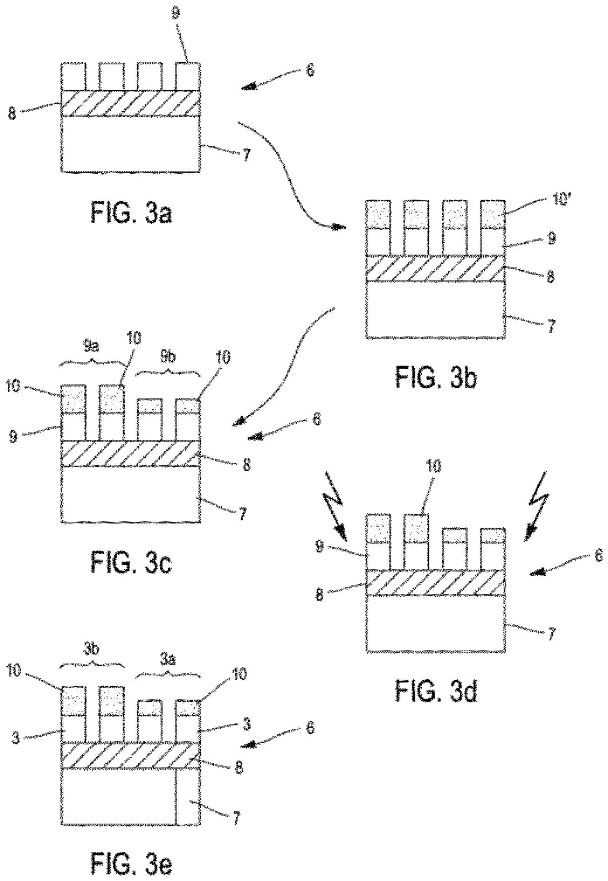

Ainsi que cela est représenté sur la figure 3a, un premier procédé de fabrication comprend la fourniture d'un substrat de relaxation comprenant un support de relaxation 7, une couche de fluage 8 disposée sur le support 7 et disposée sur la couche de fluage 8, une pluralité d'îlots cristallins semi-conducteurs contraints 9. Les îlots contraints 9 présentent tous le même paramètre de maille. On pourra se référer aux documents cités de l'état de la technique pour choisir la nature du support de relaxation 7 et de la couche de fluage 8.

Ces îlots contraints 9 peuvent provenir d'un substrat donneur, et avoir été transférés sur la couche de fluage 8 du substrat de relaxation 6 par les étapes de collage et d'amincissement évoqués brièvement ci-dessus. À titre d'exemple, le substrat donneur peut consister en un support de base en saphir, une couche tampon de GaN formée sur le substrat de base et une couche contrainte d'InGaN avec une proportion d'indium comprise entre 1% ou 1,5% et 10% ou 20% sur la couche tampon de GaN. Des étapes traditionnelles de photolithographie, de dépôt de résine et de gravure, peuvent avoir été employées pour définir à partir de la couche continue d'InGaN, les îlots contraints 9 d'InGaN. Ces étapes peuvent avoir été appliquées avant ou après les étapes de transfert. Comme on l'a évoqué ci-dessus, les îlots 3 peuvent supporter une couche raidisseur 10', résidu du substrat donneur. Il peut ainsi d'agir d'une épaisseur comprise entre 10 et 100nm de GaN qui formait initialement la couche tampon du substrat donneur.

Quelle que soit la manière avec laquelle le substrat de relaxation 6 ait été formé, on traite sélectivement dans une étape suivante du procédé de fabrication, les îlots contraints 9 du substrat de relaxation de sorte à former un premier groupe d'îlots contraints 9a présentant un premier potentiel d'expansion latérale et un deuxième groupe d'îlots contraints 9b présentant un deuxième potentiel d'expansion latérale, différent du premier. En d'autres termes, l'énergie de contrainte contenue dans un îlot du premier groupe 9a est différente de l'énergie de contrainte contenue dans un îlot du deuxième groupe 9b.

Un tel traitement sélectif peut comprendre la formation d'une couche raidisseur 10 présentant une première épaisseur sur un premier groupe d'îlots contraints 9a du substrat de relaxation 6 et une deuxième épaisseur, différente de la première, sur un deuxième groupe d'îlots 9b. Cette disposition est représentée sur la figure 3c.

Cette configuration d'épaisseur de la couche raidisseur 10 peut être obtenue en formant une couche raidisseur initiale d'épaisseur uniforme 10' sur tous les îlots 9, comme cela est représenté sur la figure 3b, puis en amincissant sélectivement cette couche 10' pour en réduire l'épaisseur sur l'un des deux groupes d'îlots 9a, 9b. On peut à nouveau employer des étapes de masquage photo lithographique pour protéger de ce traitement d'amincissement la couche raidisseur 10 disposée sur l'un des groupes d'îlots. Alternativement à un amincissement, on peut également choisir d'épaissir la couche raidisseur initiale 10' sur un des deux groupes d'îlots 9a, 9b pour aboutir à la configuration de la figure 3c. Comme on l'a vu, cette couche raidisseur d'épaisseur uniforme 10' peut consister en un résidu du substrat donneur.

En alternative ou en complément, on pourra choisir, plutôt que de modifier l'épaisseur de la couche raidisseur 10 d'un groupe d'îlot à un autre, de faire varier sa nature. On peut ainsi disposer sur un premier groupe d'îlot 9a une couche raidisseur 10 formée d'un premier matériau et disposer sur le deuxième groupe d'îlots 9b une couche raidisseur 10 formée d'un second matériau présentant une raideur ou une rigidité différente du premier. Dans ce cas, la couche raidisseur 10 peut présenter une épaisseur uniforme d'un groupe d'îlots contraint 9a, 9b à l'autre.

Pour des raisons de disponibilité et de coût, la couche raidisseur 10 est typiquement constituée d'un oxyde de silicium ou d'un nitrure de silicium. Mais il peut s'agir de tout autre matériau suffisamment rigide pour modifier le potentiel d'expansion latéral de l'îlot 9 sur lequel il repose et, potentiellement éviter le gauchissement de cet îlot 9 au cours du traitement thermique de relaxation qui va suivre. Selon la nature de cette couche, et du degré de relaxation attendu de l'îlot 9 sur laquelle elle est disposée, la couche raidisseur 10 peut présenter une épaisseur comprise entre 10 nm et plusieurs centaines de nm, comme 200 nm.

On peut également prévoir que certains îlots 9 ne soient pas recouverts d'une couche raidisseur 10. C'est particulièrement le cas lorsque le degré de contrainte de l'îlot est relativement faible, et donc que le risque de gauchissement de cette couche peu présent.

Le traitement sélectif visant à affecter de manière différenciée la capacité latérale d'expansion des îlots 9 peut également comprendre l'amincissement de certains des îlots 9, c'est-à-dire de réduire l'épaisseur des îlots 9a du premier groupe d'îlots et/ou l'épaisseur des îlots 9b du deuxième groupe d'îlots de sorte que ces îlots 9a, 9b, à l'issue de ce traitement présentent des épaisseurs différentes. Il peut par exemple s'agir d'amincir au moins un groupe d'îlots 9a, 9b de 10% à 50% de son épaisseur initiale, afin de créer une différence d'épaisseur entre ces groupes d'îlots pouvant être supérieure à 10%. Cette variante est particulièrement utile lorsque la couche raidisseur a été formée entre la couche de fluage 8 et l'îlot 9a, 9b semi-conducteur cristallin, par exemple en plaçant une couche de matériau raidisseur sur le substrat donneur, avant le transfert de la couche contrainte sur le support de relaxation.

Dans une variante non représentée, la couche raidisseur est formée sous certains seulement des îlots contraints 9. La couche raidisseur peut être formée préalablement formée sur la surface exposée du substrat donneur 11 et gravée localement de manière à sélectivement former des îlots avec ou sans cette couche sous-jacente, ou avec une épaisseur variable de cette couche raidisseur. Les îlots 9 ayant une couche raidisseur sous-jacente auront un potentiel d'expansion latérale plus faible que les îlots sans couche raidisseur, pour une couche de fluage identique.

Tous les traitements sélectifs qui viennent d'être décrits peuvent être combinés entre eux. Dans tous les cas, à l'issue de ce traitement visant à former au moins deux groupes d'îlots 9a, 9b, on dispose d'un premier groupe d'îlots 9a présentant au moins une caractéristique (épaisseur, épaisseur ou nature d'une couche de raidisseur supportée) qui diffère de la caractéristique d'un deuxième groupe d'îlots 9b. En conséquence, ils présentent une capacité ou un potentiel d'expansion latérale qui diffère.

Dans une étape suivante du procédé de fabrication, représentée sur la figure 3d, on traite thermiquement le substrat de relaxation 6 à une température supérieure ou égale à la température de transition vitreuse de la couche de fluage 8. Selon la nature de cette couche, ce traitement thermique peut comprendre l'exposition du substrat de relaxation à une température comprise entre 400°C et 900°C pendant une durée de quelques minutes à plusieurs heures. C'est notamment le cas lorsque la couche de fluage est en BPSG. On provoque de la sorte la relaxation des îlots contraints 9 du premier et du deuxième groupe d'îlots 9a, 9b pour former des îlots au moins partiellement relaxés 3, représentés sur la figure 3e. Comme cela est bien documenté, le degré de relaxation obtenu au cours et à l'issue du traitement thermique de relaxation dépend de l'épaisseur de l'îlot 9, l'épaisseur et/ou la nature de la couche raidisseur 10 recouvrant éventuellement cet îlot 9.

Les îlots contraints du premier groupe 9a et les îlots contraints du deuxième groupe 9b présentant des caractéristiques différentes et donc un potentiel d'expansion latérale différent, le traitement thermique conduit à relaxer à des degrés différents les îlots 9 initialement contraints du premier et du second groupe 9a, 9b. En d'autres termes, à l'issue du traitement thermique de relaxation, le paramètre de maille des îlots 3 du premier groupe 3a est différent du paramètre de maille des îlots 3 du deuxième groupe 3b.

### Deuxième procédé

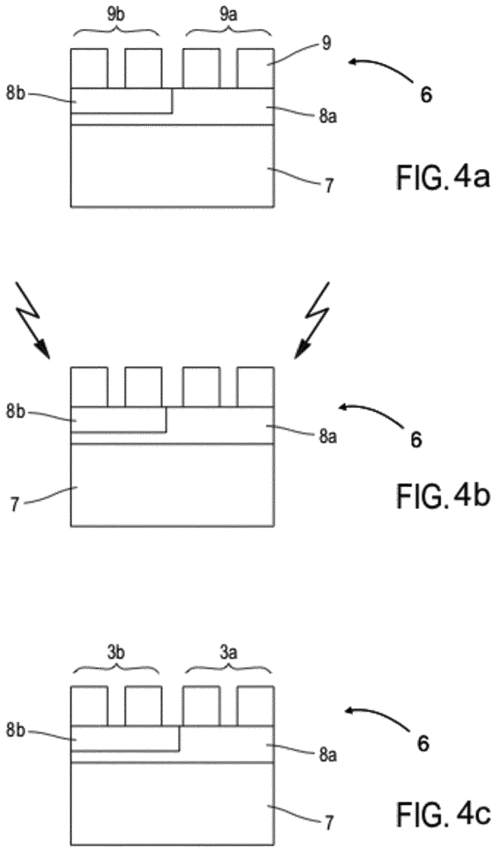

Ce deuxième procédé de fabrication d'îlots 3 présentant une variété de paramètres de maille est maintenant décrit en référence aux figures 4a à 4c. Comme pour le premier procédé on fournit un substrat de relaxation 6 comprenant un support de relaxation 7, une couche de fluage 8 disposée sur le support 7 et, disposée sur la couche de fluage 8, une pluralité d'îlots cristallins semi-conducteurs contraints 9. Les îlots contraints 9 présentent tous, initialement, le même paramètre de maille.

Dans ce deuxième procédé, et en référence à la figure 4a, la couche de fluage 8 est composée d'un premier groupe de pavés 8a et d'un deuxième groupe de pavés 8b. Ici, chaque groupe 8a, 8b est composé d'un seul pavé pour des raisons de simplification de la description, mais d'une manière générale, un groupe de pavés peut être constitué d'un ou d'une pluralité de pavés. Le terme « pavé » doit être entendu dans une acceptation très large, désignant tout bloc ou combinaison de blocs de matériau homogène, ce bloc définissant un volume quelconque, qui n'est pas nécessairement convexe.

Les pavés du premier groupe 8a et les pavés du deuxième groupe 8b sont constitués de matériaux différents, qui pour une température déterminée, présentent respectivement une première et une deuxième viscosité qui sont différentes l'une de l'autre. Les îlots 9 contraints disposés sur les pavés 8a du premier groupe forment un premier groupe d'îlots contraints 9a et, similairement, les îlots contraints 9 disposés sur les pavés 8b du deuxième groupe forment un deuxième groupe d'îlots contraints 9b.

La viscosité des pavés 8a du premier groupe étant différente de la viscosité des pavés 8b du deuxième groupe, les îlots contraints 9 sont susceptibles de se relaxer, au moins partiellement, de manière différenciée. En d'autres termes, les îlots contraints du premier groupe 9a disposent d'un potentiel de relaxation différent du potentiel de relaxation des îlots contraints 9b du deuxième groupe. Dans la mesure où les îlots contraints 9 sont tous de même dimension, l'énergie de contrainte qu'ils contiennent sont également toute similaire, mais la nature des pavés sur lesquels ils reposent étant différents, les îlots 9 sont susceptibles de se relaxer de manière différenciée.

Les îlots contraints 9 peuvent provenir d'un substrat donneur 11, et avoir été transférés sur la couche de fluage 8 du substrat de relaxation 6 par des étapes identiques ou similaires à celles présentées en relation avec la description du premier procédé.

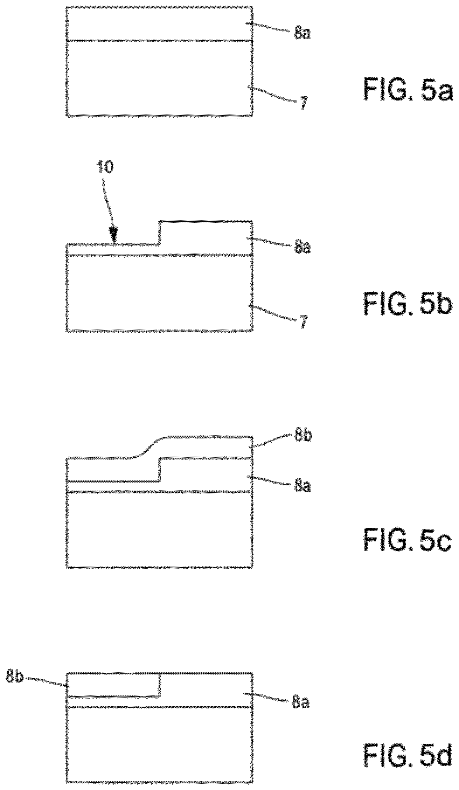

Les figures 5a à 5d représentent une séquence d'étapes possibles pour réaliser une couche de fluage 8 composé de pavés 8a, 8b de viscosités différentes. En référence à la figure 5a, on forme sur le support 7 une première couche 8a de fluage. Il peut s'agir d'une couche diélectrique de dioxyde de silicium, ou de nitrure de silicium, comprenant une proportion déterminée de bore et/ou de phosphore pour lui donner une première valeur de viscosité. Dans l'étape suivante, représentée sur la figure 5b, on aménage au moins un évidement 10 par masquage partiel et gravure de la première couche de fluage 8a. L'évidement 10 peut être partiel, comme représenté sur la figure, ou correspondre à toute l'épaisseur de la première couche de fluage 8a. Dans une étape suivante, on recouvre la première couche 8a restante et l'évidement 10, d'une seconde couche de fluage 8b. Cette seconde couche 8b, préférablement, présente une épaisseur suffisante pour remplir entièrement l'évidement 10. Le matériau constituant la deuxième couche de fluage 8b est de nature différente de la première couche 8a de sorte que la première et la deuxième couche présentent une viscosité différente lorsqu'elles sont exposées à une température déterminée de relaxation.

Cette viscosité différente peut être indifféremment plus importante ou plus faible que celle de la première couche 8a. Par exemple, si la première couche est en dioxyde de silicium ou en nitrure de silicium, qui présente des viscosités particulièrement élevées, on pourra choisir le matériau de la deuxième couche 8b en BPSG, avec une proportion massique de bore et de phosphore suffisant, par exemple supérieur à 4 %, pour présenter une viscosité plus faible que celle de la première couche.

En référence à figure 5d, on planarise ensuite la surface exposée du substrat pour éliminer la deuxième couche de fluage en dehors des évidements 10 jusqu'à exposer la première couche de fluage 8a. On forme de la sorte les premiers pavés 8a et les deuxièmes pavés 8b constituant la couche de fluage 8. On note que la couche de fluage 8 ainsi réalisée présente une surface particulièrement plane qui la rend propice à recevoir les îlots contraints 9 par transfert de couche.

Revenant au deuxième procédé de fabrication, et dans une étape suivante de ce procédé représentée sur la figure 4b, on traite thermiquement le substrat de relaxation 6 à une température de relaxation supérieure ou égale à la température de transition vitreuse de la couche de fluage, c'est-à-dire d'au moins un des premier et deuxième pavés 8a, 8b de la couche de fluage 8 pour provoquer la relaxation différenciée des îlots 9a, 9b du premier et du second groupe. Selon la nature des pavés constituant cette couche, le traitement thermique peut comprendre l'exposition du substrat de relaxation 6 à une température de relaxation comprise entre 400°C et 900°C pendant une durée de quelques minutes à plusieurs heures. On provoque de la sorte l'expansion latérale des îlots contraints 9 du premier et du deuxième groupe d'îlots 9a, 9b pour former des îlots au moins partiellement relaxés 3, représentés sur la figure 4c.

En d'autres termes, les îlots contraints du premier groupe 9a et les îlots contraints du deuxième groupe 9b reposants sur des pavés présentant une viscosité différente à la température du traitement thermique de relaxation, et donc présentant un potentiel d'expansion latérale différent, le traitement thermique conduit à relaxer à des degrés différents les îlots 9 initialement contraints du premier et du second groupe 9a, 9b, et à provoquer leur expansion latérale différenciée. Par conséquent, à l'issue du traitement thermique de relaxation, le paramètre de maille des îlots 3 du premier groupe 3a est différent du paramètre de maille des îlots 3 du deuxième groupe 3b.

### Troisième méthode

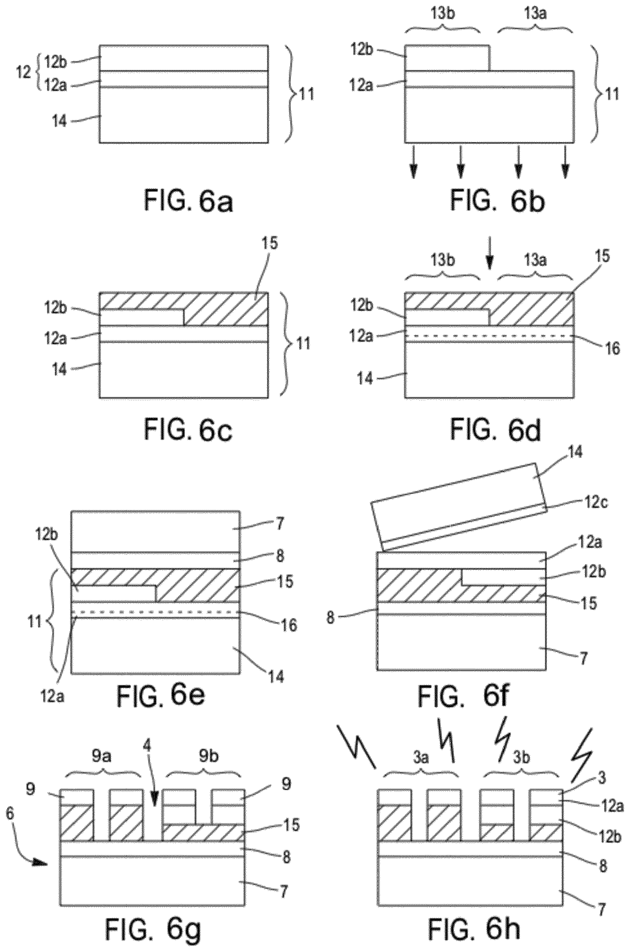

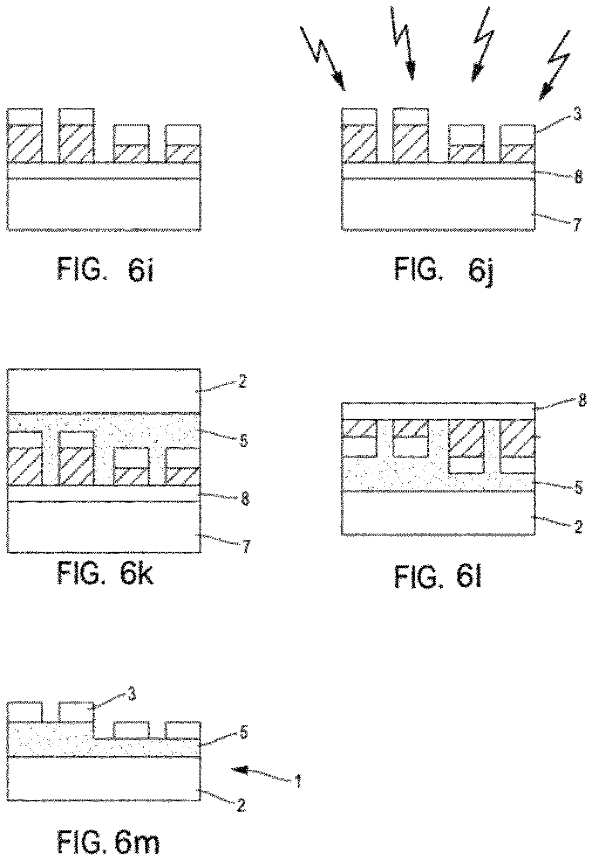

On présente en référence aux figures 6a à 6m, un troisième procédé pour fournir des îlots 3 relaxés présentant une variété de paramètres de maille. Ce troisième procédé comprend la préparation d'un substrat donneur 11 comprenant une pluralité de couches élémentaires contraintes de semi-conducteurs cristallins 12a, 12b formant un empilement 12. L'empilement présente au moins une première zone 13a et une deuxième zone 13b ayant des niveaux de contraintes différents.

Sur la figure 6a, on a représenté la première étape de préparation du substrat donneur 11. Elle comprend la fourniture d'un substrat de base 14, par exemple constitué de saphir, de silicium ou de carbure de silicium. On forme sur le substrat de base 14 un empilement 12 de couches élémentaires semi-conductrices et cristallines, chaque couche de l'empilement présentant une nature différente. Dans l'exemple représenté sur la figure 3a, on a formé deux couches élémentaires semi-conductrices cristallines 12a, 12b. À titre d'illustration, la première couche élémentaire 12a peut-être une couche de nitrure de gallium présentant une épaisseur de 2 microns ou plus, formant une couche tampon et dont la partie supérieure est essentiellement relaxée. La deuxième couche élémentaire 12b peut-être une couche d'InGaN d'épaisseur environ 100 nm et dont la proportion d'indium est de 6 % environ. La deuxième couche élémentaire 12b de l'empilement 12, et d'une manière générale chaque couche élémentaire de l'empilement 12, présente une épaisseur inférieure à son épaisseur critique de relaxation. Certaines au moins des couches sont donc contraintes, en compression dans l'exemple pris ci-dessus. De cette façon, la deuxième couche élémentaire 12b (ou chaque couche de l'empilement 12 formée sur la première couche élémentaire 12a) est pseudomorphe et présente donc un paramètre de maille identique à celui de la première couche 12a de l'empilement 12.

On a représenté sur la figure 6b une étape suivante de la préparation du substrat donneur 11, consistant à éliminer localement la deuxième couche élémentaire 12b pour exposer une partie de la première couche élémentaire 12a. Cette étape d'élimination peut mettre en oeuvre des moyens traditionnels de masquage photolithographique et de gravure, par exemple une gravure sèche. On définit de la sorte, à la surface exposée du substrat donneur 11, une première zone 13a dans laquelle la première couche 12a est exposée, et une deuxième zone 13b où la deuxième couche 12b de l'empilement est exposée. De manière générale, au cours de cette étape, on élimine localement une partie l'empilement 12 de manière à préserver dans des zones 13 respectives, une partie seulement des couches formant l'empilement 12. Les zones 13 présentent des niveaux de contraintes différentes les unes des autres, car chaque zone 13 est respectivement formée d'un empilement différent d'une, ou d'une pluralité de couches élémentaires, chacune dans un état de contraintes différent.

Ainsi, dans l'exemple représenté sur la figure 6b, la zone 13a est constituée de la première couche 12a et présente un premier niveau de contrainte de référence. La zone 13b est constituée de l'empilement formé de la première couche élémentaire 12a et de la deuxième couche élémentaire 12b contrainte. La deuxième zone 13b présente donc un niveau de contrainte supérieure à celui de la première zone 13a.

Les zones 13a, 13b ne sont pas de nécessairement d'un seul tenant, c'est-à-dire que l'élimination locale des couches élémentaires de l'empilement 12 pour exposer une couche particulière peut être réalisée en une pluralité d'emplacements distincts et non jointifs. On désignera par le terme « zone », la collection des emplacements à la surface du substrat donneur 11 présentant un même niveau de contrainte, par exemple pour lesquels la même couche 12a, 12b de l'empilement 12 est exposée à l'issue de cette étape d'élimination.

La première et la deuxième zone 13a, 13b du substrat donneur vont chacune permettre de respectivement constituer les îlots 3 du premier et du deuxième groupe d'îlots relaxés 3a, 3b d'un substrat de croissance 1. On cherchera donc à définir ces zones à la surface du substrat donneur 11 pour qu'elles correspondent à la disposition choisie des îlots 3 des groupes d'îlots 3a, 3b, comme cela a été exposé précédemment en relation aux figures 2a à 2c.

Les étapes suivantes de préparation du substrat donneur 11, représentées sur les figures 6c et 6d visent à préparer le transfert de l'empilement 12 ainsi défini sur un support de relaxation 7.

Pour permettre l'assemblage du substrat donneur 11 sur le support 7, on prévoit ainsi de former une couche collage 15 présentant une surface exposée plane et lisse. Il peut s'agir d'une couche de diélectrique, par exemple de dioxyde de silicium ou de nitrure de silicium. Quand il s'agit de dioxyde de silicium, celui-ci peut comprendre du bore et/ou du phosphore pour lui conférer des propriétés de fluage lorsque la couche de collage 15 est exposée à une température supérieure à sa température de transition vitreuse. Cette couche de collage 15 est déposée avec une épaisseur suffisante pour permettre d'encapsuler entièrement l'empilement 12 et ainsi fournir une surface plane. Lorsque sa formation prévoit d'appliquer une étape de polissage, on prendra en compte l'enlèvement d'épaisseur qui intervient au cours de ce traitement. À titre d'exemple, on peut déposer une épaisseur de 500 nm ou plus du matériau pour former la couche de collage 15.

Dans une étape facultative représentée sur la figure 6d, on introduit dans le substrat donneur 11 des espèces légères, telles que de l'hydrogène ou de l'hélium. L'introduction de ces espèces conduit à former un plan fragile 16 permettant d'éliminer, dans une étape ultérieure du procédé de fabrication, le substrat de base 14 et permettre le transfert de l'empilement 12 sur le support de relaxation 7. Le plan fragile 16 peut être préférablement localisé dans le support de base 14 ou dans la première couche élémentaire 12a de l'empilement 12, de manière à ce que l'empilement 12 soit effectivement transféré sur le support 7.

On notera qu'il est possible, lorsque l'introduction des espèces légères est réalisée par implantation d'ions à travers la couche de collage 15 et à travers les couches élémentaires de l'empilement 12, que le plan de fragilisation 16 ne soit pas parfaitement plan. Cela n'a pas de conséquences pour l'application du procédé de fabrication, dans la mesure où ce plan reste bien localisé dans l'empilement 12. On peut également prévoir d'inverser l'ordre des étapes de formation de la couche de collage 15 et de formation du plan fragile 16 pour prévenir ce phénomène. On peut également prévoir de former le plan fragile 16 avant de définir les zones 13 présentant des niveaux de contraintes différents. Dans ces deux cas, on fera alors en sorte, qu'au cours de la formation de la couche de collage 15, le substrat donneur 11 ne soit pas exposé à un budget thermique excessif qui provoquerait la déformation de l'empilement par effet de bullage des espèces implantées.

On a représenté sur les figures 6e et 6f, respectivement, l'assemblage du substrat donneur 11 avec le support de relaxation 7, et le retrait du support de base 14 et d'un résidu 12c de la première couche élémentaire 12a. Le retrait s'opère après la fracture de l'assemblage au niveau du plan de fragilisation 16, ici disposé dans la première couche élémentaires 12a. Cette étape de retrait peut comprendre l'exposition de l'assemblage à une température modérée de quelques centaines de degrés et/ou l'application d'efforts, par exemple d'origine mécanique.

Toutefois, ce troisième procédé de fabrication n'est nullement limité à un transfert mettant en oeuvre la formation d'un plan de fragilisation 16. On peut envisager d'opérer le transfert sur le support 7 par enlèvement mécano-chimique du support de base 14 notamment lorsque celui-ci est en silicium. On peut également envisager son détachement par irradiation laser de l'interface séparant le substrat de base 14 et la première couche élémentaire 12a, notamment lorsque ce substrat de base est en saphir.

Le support de relaxation 7 a été préalablement muni d'une couche de fluage 8 si bien qu'après l'opération de retrait du support de base 14, on dispose d'un substrat de relaxation 6 comprenant le support de relaxation 7, la couche de fluage 8, la couche de collage 15, et l'empilement 12 des couches élémentaires de semi-conducteurs cristallins contraints définissant des zones 13 présentant des niveaux de contraintes différents.

Dans l'étape suivante, représentée sur la figure 6g, on réalise des tranchées 4 dans l'empilement 12 de manière à définir des îlots contraints 9. Les tranchées 14 sont réalisées dans l'empilement 12 pour définir les îlots 9 d'un premier groupe 9a dans la première zone 13a, et les îlots 9 d'un deuxième groupe d'îlots 9b dans la deuxième zone 13b. Ces tranchées 4 peuvent pénétrer dans la couche de collage 15 voire même dans la couche de fluage 8. Cette étape de définition des îlots 9 peut être réalisée après le transfert d'une partie au moins de l'empilement 12 comme cela a été présenté ici, mais on peut également envisager de réaliser cette étape préalablement au transfert de l'empilement 12, directement sur le substrat donneur 11. Comme on l'a vu, la formation des tranchées 4 peut conduire à définir des îlots 9 de formes et de dimensions très variées.

En tout état de cause, on dispose à l'issue de ces étapes un substrat de relaxation 6 comprenant un support 7, une couche de fluage 8 disposé sur le support et une couche de collage 15 disposée sur la couche de fluage 8. Comme on l'a vu, la couche de fluage 8 et la couche de collage 15 peuvent toutes les deux être constituées de BPSG et présenter donc des propriétés de fluage. Le substrat de relaxation 6 comprend également, sur la couche de fluage 8, une pluralité d'îlots semi-conducteurs cristallins présentant tous le même paramètre de maille initial. Un premier groupe d'îlots 9a présente un premier niveau de contraintes. Il s'agit des îlots 9 qui ont été formés dans l'empilement 12 au niveau de la première zone 13a de cet empilement. Un deuxième groupe d'îlots 9b présente deuxième niveau de contrainte, différent du premier. Ces îlots 9 du deuxième groupe 9b sont ceux qui ont été formés dans l'empilement 12 au niveau de la deuxième zone 13b de cet empilement.

D'une manière plus générale, le substrat de relaxation 6 peut comporter une pluralité de groupes d'îlots ayant entre eux des niveaux de contrainte différents, chaque groupe d'îlots ayant été formé, dans l'empilement 12, au niveau d'une zone 13 distincte de cet empilement 12. Les îlots contraints 9 de chaque groupe d'îlots présentent un potentiel d'expansion latéral différent d'un groupe à l'autre. Ainsi, l'énergie de contrainte contenue dans un îlot 9 du premier groupe 9a est différente de l'énergie de contrainte contenue dans un îlot 9 du deuxième groupe 9b.

Pour libérer cette énergie de contrainte et provoquer l'expansion latérale différenciée des îlots 9 du premier groupe 9a et des îlots 9 du deuxième groupe 9b, et similairement au premier et deuxième procédé qui ont été exposés, on prévoit de traiter thermiquement le substrat de relaxation 6. Comme pour les autres procédés, il peut s'agir par exemple d'un traitement thermique portant le substrat 6 à 800°C pendant quatre heures. D'une manière plus générale, on choisira la température de relaxation de ce traitement thermique pour qu'il excède la température de transition vitreuse de la couche de fluage 8, et éventuellement celle de la couche de collage 15 lorsque celle-ci présente des propriétés de fluage. Cette température de relaxation est typiquement comprise entre 400°C et 900°C. Le traitement thermique peut durer entre 30 minutes et plusieurs heures.

Bien entendu, si un groupe d'îlots 9 n'est pas dans un état contraint, comme cela est le cas des îlots 9 constitués de la première couche 12a en nitrure de gallium de l'exemple précédent, le paramètre de maille de ces îlots n'est pas affecté par le traitement thermique de relaxation.

En tout état de cause, les îlots formant les différents groupes d'îlots 9a, 9b présentant initialement des niveaux de contraintes différents, l'application du traitement thermique de relaxation conduit à la relaxation et à l'expansion latérale différenciée des îlots d'un groupe à l'autre. Les îlots relaxés 3 du premier groupe 3a et les îlots 3 du second groupe 3b présentent alors des paramètres de maille différents.

On a ainsi représenté à titre d'illustration sur les figures 6h et 6j deux traitements thermiques de relaxation conduisant à relaxer de manière différente les îlots contraints 9. Entre ces deux étapes, et comme représenté sur la figure 3i, on a réalisé une étape de réduction d'épaisseur des îlots partiellement relaxés 3 du deuxième groupe d'îlots 3b. Dans l'exemple représenté, cette réduction d'épaisseur a conduit à éliminer de ces îlots 3 la portion d'épaisseur correspondant à la couche originelle 12a de manière à exposer la couche originelle 12b. Mais ce choix n'est nullement limitatif, et on aurait pu préserver une partie de la couche originale 12a, des îlots du deuxième groupe 3b ou amincir l'ensemble des îlots 3 de chaque groupe d'îlots 3a, 3b.

À l'issue de ce troisième procédé de fabrication qui vient d'être décrit, on peut choisir de procéder au transfert des îlots au moins partiellement relaxées 3 sur un autre support. En référence aux figures 6k à 6m, on peut par exemple transférer les îlots 3 sur un support de croissance 2 par l'intermédiaire d'une couche d'assemblage 5. À cet effet, on recouvre les îlots 3 de la couche d'assemblage 5, on assemble cette couche, qui peut avoir subi des traitements pour faciliter cela, au support de croissance 2 (figure 6k) et élimine le support de relaxation 7 par tous moyens appropriés pour obtenir la structure de la figure 3l. On élimine ensuite de la structure obtenue la couche de fluage 8 et la couche de collage 15. Des étapes de gravure complémentaires peuvent permettre d'éliminer la couche d'assemblage 5 en excès, permettant alors de disposer d'un substrat de croissance 1 (figure 6m) tel que décrit précédemment en relation avec la figure 1b.

Quelle que soit la méthode employée pour fournir les îlots relaxés, le degré de relaxation obtenu au cours et à l'issue du traitement thermique de relaxation dépend, entre autres choses, de la dimension d'un îlot 9, de son niveau de contrainte, et de la nature de la couche de fluage 8 sur lequel il repose, et plus particulièrement de la viscosité du matériau qui compose cette couche (ou ce pavé dans le cas du deuxième procédé).

Et quelle que soit la méthode employée, on pourra également prévoir de modifier l'épaisseur des îlots ou d'amincir/épaissir une éventuelle couche raidisseur des îlots du premier groupe et/ou du second groupe d'îlots 3a, 3b, ou de tout autre groupement d'îlots, avant d'appliquer une étape de traitement thermique de relaxation additionnelle. On peut de la sorte affiner, en répétant l'application du traitement thermique de relaxation, les paramètres de maille des îlots 3 disposés sur le substrat de relaxation 6. Comme on l'a déjà évoqué, on peut bien entendu envisager de former plus de deux groupes d'îlots 3a, 3b.

On pourra prévoir, dans le cas de la première méthode, une étape de traitement thermique de relaxation préliminaire avant de sélectivement traiter les îlots 9 pour les différencier. On relaxe dans ce cas tous les îlots 9 au même degré de relaxation. On pourra également prévoir dans chacune des trois procédés exposés, de modifier l'épaisseur des îlots ou d'amincir/épaissir la couche raidisseur 10 des îlots du premier groupe et/ou du second groupe d'îlots 3a, 3b, ou de tout autre groupement d'îlots, avant d'appliquer une étape de traitement thermique de relaxation additionnelle. On peut de la sorte affiner, en répétant un cycle de traitement sélectif des îlots et d'application du traitement thermique de relaxation, les paramètres de maille des îlots 3 disposés sur le substrat de relaxation 6. Comme on l'a déjà évoqué, on peut bien entendu envisager de former plus de deux groupes d'îlots 3a, 3b.

D'une manière plus générale et indépendamment de la méthode employée, on pourra combiner toute étape visant à modifier une caractéristique d'un groupe d'îlots 9a, 9b affectant son potentiel d'expansion latéral, pour que chaque îlot présente à l'issue du traitement thermique de relaxation un paramètre de maille proche ou identique à un paramètre de maille cible.

À l'issue de l'un quelconque des procédés de fabrication qui viennent d'être décrits, on peut choisir de procéder au transfert des îlots relaxés 3 sur un autre support, comme cela a été illustré pour le troisième procédé. Ce transfert peut comprendre le report des îlots sur un support intermédiaire, avant de les transférer sur cet autre support. On peut par exemple choisir de transférer les îlots 3 sur un support de croissance 2, par l'intermédiaire éventuel d'une couche d'assemblage 5, permettant alors de disposer d'un substrat de croissance 1 tel qu'il a été décrit précédemment et représenté sur la figure 1a (pour le premier et le deuxième procédé) et sur la figure 1b (pour le troisième procédé). On dispose de la sorte d'un substrat de croissance ne comportant pas de couche de fluage, celle-ci pouvant être incompatible avec les étapes de fabrication des couches actives de dispositifs optoélectroniques. De plus, ce transfert permet dans le cas où les îlots sont constitués d'un matériau polaire, de récupérer sur la face exposée du support de croissance 1 la polarité initiale de ce matériau, tel qu'il avait été formé sur le substrat donneur.

### Procédé de fabrication d'une pluralité de dispositifs optoélectroniques.

Selon un autre aspect, un procédé de fabrication collective d'une pluralité de dispositifs optoélectroniques est décrit. L'invention porte sur ce procédé d'utilisation du substrat de croissance. Ces dispositifs comportent chacun des couches actives pouvant être différentes d'un dispositif à un autre. Les dispositifs présentent alors des propriétés optoélectroniques différentes les unes des autres. Par l'expression « fabrication collective », on signifie que la fabrication de ces dispositifs emploie une unique technologie appliquée à un unique substrat pour former les couches actives.

Ce procédé comprend la fourniture d'un substrat de croissance 1, conforme à la description générale qui vient d'en être faite. Il comporte donc au moins un premier groupe d'îlots semi-conducteurs cristallins 3a présentant un premier paramètre de maille et un deuxième groupe d'îlots semi-conducteurs cristallins 3b présentant un deuxième paramètre maille, différent du premier.

L'étape suivante vise à former les couches actives par croissance sur la face exposée de ces îlots 3. Comme cela est bien connu en soi, le substrat de croissance est placé pour cela dans une chambre de dépôt, par exemple celle d'un bâti d'épitaxie. Lors du dépôt, une telle chambre est parcourue par des flux de gaz précurseurs, ces gaz comprenant les éléments atomiques constituant les couches actives que l'on souhaite déposer sur les îlots 3. Les gaz précurseurs sont portés en température au-dessus du substrat de croissance 1 de manière à libérer les éléments atomiques, et permettre leurs adsorptions à la surface du substrat de croissance 1 et notamment à la surface des îlots 3. Selon la nature, la concentration relative et la durée de circulation de ces gaz précurseurs, on peut contrôler la nature et l'épaisseur des couches qui se forment progressivement sur les îlots semi-conducteurs cristallins 3. Si cela est nécessaire, on peut prévoir d'introduire dans la chambre des dopants, de type p ou n, pour élaborer des couches dopées. On peut notamment contrôler les gaz précurseurs pour former, sur les îlots, des couches actives de dispositif électronique, tels que des puits quantiques ou des hétérostructures de DELs.

A titre d'exemple, une couche active de DELs peut comprendre, sur un îlot 3 formé d'InGaN présentant une concentration d'In inférieure à 20% et au moins partiellement relaxé (typiquement de l'ordre de 70% ou 90%),l'empilement de couches suivantes :
- une couche d'InGaN dopé n présentant une concentration d'In similaire à celle de l'îlot 3 ;
- un puits quantique multiple comportant une pluralité de couches, chaque couche comprenant une proportion d'indium distincte, présentant quelques pour cent d'écart de celle de la couche dopée n sous-jacente. Le puits quantique est susceptible d'émettre un rayonnement lumineux longueur d'onde choisie, selon la nature des couches qui le forme ;
- une couche d'InGaN dopé p présentant une concentration d'In comprise entre 0 et 10%. Pour simplifier sa fabrication, on peut également choisir de former la couche dopée p en GaN.

Les gaz précurseurs pour former ces couches actives de DELs peuvent comprendre du trimethylegalium (TMGa), du triethylgallium (TEGa), du trimethylindium (TMIn) et de l'ammoniaque (NH3).

L'incorporation de certains éléments atomiques des gaz précurseurs dans la couche déposée est affectée par le paramètre de maille de cette couche. C'est notamment le cas pour ce qui concerne l'incorporation d'indium dans une couche d'InGaN comme cela a été reporté dans le document « Strain effects on indium incorporation and optical transitions in green-light InGaN heterostructures of différent orientations. », de M.V Durnev et al, Phys. Status Solidi A 208, No. 11, 2671-2675 (2011). Il apparaît que la solubilité de l'indium dans un matériau augmente lorsque le paramètre de maille de ce matériau augmente. En d'autres termes, et toutes choses étant égales par ailleurs, l'incorporation d'indium dans un matériau au cours de sa formation par dépôt croit avec le paramètre de maille du matériau dans lequel il est incorporé.

On met à profit cette observation pour former sur le substrat de croissance 1 des couches actives d'une pluralité de dispositif optoélectronique, ces couches actives pouvant être différentes d'un dispositif à un autre. D'une manière générale, le procédé met en oeuvre une étape d'exposition du substrat de croissance 1 à une atmosphère comprenant au moins une concentration initiale d'un élément atomique.

Sur les îlots 3 du premier groupe 3a du substrat de croissance 1, qui présente un premier paramètre de maille, l'élément atomique est incorporé dans la couche active dans une première concentration. Sur les îlots 3 du deuxième groupe d'îlots 3b, qui présente un deuxième paramètre de maille différent du premier, l'élément atomique est incorporé dans la couche active selon une seconde concentration, différente de la première. Si le deuxième paramètre de maille est supérieur au premier, la deuxième concentration sera supérieure à la première.

En d'autres termes, la première et la seconde concentration sont déterminées par la concentration initiale de l'espèce atomique dans la chambre et par le premier et le deuxième paramètre de maille des îlots. Comme cela est bien connu dans le domaine de la croissance des matériaux, d'autres paramètres peuvent également influencer la nature des couches qui se forment, comme par exemple la pression de la chambre, la température, le débit respectif des précurseurs....

En fournissant un substrat de croissance pour lequel le premier et le deuxième paramètre de maille ont été convenablement choisis, on peut donc former des couches actives présentant des propriétés optoélectroniques différentes. A titre d'exemple, la proportion d'indium incorporée dans les couches actives d'InGaN déposées sur les îlots du premier groupe d'îlots peut conduire à former des DELS émettant directement un rayonnement dans le domaine du bleu. Simultanément, la proportion d'indium incorporée dans les couches actives d'InGaN déposées sur les îlots du deuxième groupe d'îlots peut conduire à former des DELS émettant directement un rayonnement dans le domaine du vert.

Une fois les couches actives formées sur les îlots, on peut poursuivre le procédé de fabrication des dispositifs électroniques, notamment pour former les contacts électriques et isoler les dispositifs les uns des autres comme cela est par exemple décrit dans le document US9478707. On peut également prévoir de reporter des îlots 3 munis de leurs couches actives sur un support de DELs, et d'éliminer le support de croissance 2.

### Application à la fabrication d'un micro panneau monolithique de DELs et à un micro-écran d'affichage.

Une application particulière du substrat de croissance et du procédé de fabrication collective qui viennent d'être décrit, vise à fabriquer un micro panneau monolithique de DELs.

On rappelle qu'un tel micro panneau consiste en un arrangement de DELs, généralement toutes identiques et de très petites tailles, disposées à pas constant en lignes et en colonnes sur un support de panneaux. Lorsque les DELs ont été fabriquées collectivement, le micro panneau est dit « monolithique ». Cette caractéristique est avantageuse, car les DELs présentent alors des propriétés (comme le comportement en courant et/ou en tension, l'évolution au vieillissement, etc.) très similaires, ce qui facilité la conception et la fabrication du micro panneau. Dans le cadre de la présente description, on désignera par micro panneau monolithique de DELs un micro panneau dont toutes les DELs ont été fabriquées collectivement et extraites collectivement d'un même support de fabrication pour former le micro panneau ; ou un micro panneau composés de pixels monolithiques, c'est-à-dire que chaque pixel est constitué de DELs fabriquées collectivement et extraites d'un même support de fabrication. Dans ce cas, les pixels monolithiques sont assemblés entre eux pour former le micro panneau.

Le micro panneau monolithique de DELs peut être assemblé à un circuit de pilotage par une technologie de report direct de puces (souvent désigné par l'appellation anglo-saxonne « Flip Chip ») permettant de mettre en liaison électrique chaque DEL du micro panneau avec un circuit d'attaque du circuit de pilotage. Cet assemblage peut consister à assembler un micro panneau monolithique entier à un circuit de pilotage, chaque DEL du micro panneau étant après assemblage associée à un circuit d'attaque. Ou l'assemblage peut consister à assembler successivement un ou une pluralité de pixels monolithiques au circuit de pilotage pour les associer au circuit de pilotage. Quelle que soit l'approche choisie, on forme de la sorte un micro-écran d'affichage monolithique.

Les DELs ayant toutes des propriétés électriques identiques ou similaires, les circuits d'attaque du circuit de pilotage peuvent également avoir des propriétés électriques identiques ou similaires, ce qui facilite grandement la fabrication du micro-écran d'affichage.

Un exposé détaillé sur ce dispositif et sa méthode de fabrication peut être trouvé dans « Monolithic LED Microdisplay on Active Matrix Substrate Using Flip-Chip Technology » Liu et Al, IEEE Journal of Selected Topics in Quantum Electronics (Volume: 15, Issue: 4, July-aug. 2009)

On note que les micro panneaux monolithiques connus sont tous constitués de DELs émettant directement une unique longueur d'onde, permettant donc un affichage monochrome. L'affichage en couleur est obtenu par l'intermédiaire de phosphore de conversion placé sur la face d'émission de certaines de ces DELs, ou en combinant optiquement une pluralité de micro panneaux émettant chacun un rayonnement choisi dans une combinaison de couleurs complémentaires, par exemple rouge, vert et bleu. Ces techniques ne sont pas avantageuses pour des raisons évidentes de complexité de mise en oeuvre d'efficacité et de compacité comme cela a été rappelé en introduction de la présente demande.

Les procédés et substrats conformes à la présente description permettent au contraire de proposer un micro panneau monolithique de DELs comprenant un support de panneau et une pluralité de DELs disposée sur ce panneau. La pluralité de DELs comprend un premier groupe de DELs susceptible d'émettre directement un rayonnement lumineux présentant une première longueur d'onde, et un deuxième groupe de DELs susceptible d'émettre directement un deuxième rayonnement lumineux présentant une deuxième longueur d'onde différente de la première.

Un micro panneau est donc susceptible d'émettre différentes couleurs sans nécessiter de combiner optiquement une pluralité de micro panneaux ou d'appliquer des moyens de conversion. Pour les applications dans le domaine de l'affichage couleur, le micro panneau comprend au moins trois groupes de DELs, chaque groupe émettant à une longueur d'onde différente des autres. On peut par exemple avoir un premier groupe de DELs émettant directement dans le rouge, un deuxième groupe de DELs émettant directement un rayonnement dans le vert et un troisième groupe de DELs émettant directement un rayonnement dans le bleu. On peut également envisager de disposer d'un quatrième groupe de DELs émettant directement dans l'infrarouge, cette illumination pouvant être employée pour fournir des fonctionnalités additionnelles au dispositif intégrant le micro panneau (fonction tactile, reconnaissance de l'iris de l'œil, détection de mouvement...) .

Pour les applications dans le domaine de l'affichage couleur, les DELs de chaque groupe sont disposées régulièrement sur le support de panneau, par exemple espacés à pas constant le long de lignes et de colonnes, afin de former une matrice d'affichage. Ils sont également disposés pour placer côte à côte, ou plus précisément à proximité les uns des autres, une DEL de chaque groupe, de manière à former à chaque emplacement de la matrice un pixel lumineux dont la couleur peut être contrôlée. La taille des DELs peut varier suivant le groupe afin de jouer sur la répartition des intensités lumineuses des différentes couleurs d'émission. Par exemple, les DELs rouges pourront être plus larges que les DELs bleus et vertes.

Le micro panneau peut être constitué de DELs permettant de former une matrice de pixels de grandes dimensions par exemple de 50 pixels sur 50 pixels, ou de 200 pixels sur 200 pixels, voire plus.

Bien que les pixels lumineux du panneau constitué de DELs émettant dans des longueurs d'onde différente, ces DELs ont été formées collectivement à partir d'une unique technologie et sur un unique substrat. Elles présentent donc des propriétés, et notamment des propriétés électriques et de vieillissement, très similaire entre elles ce qui permet de les associer à un circuit de pilotage constitué de circuit d'attaque tous identique ou très similaire.

On expose maintenant plusieurs exemples de préparation d'un micro panneau et/ou d'un micro-écran d'affichage mettant en oeuvre un des trois procédés détaillés de fabrication d'îlots présentant une variété de paramètres de maille.

### Premier exemple

Dans ce premier exemple, on prépare en premier lieu un substrat de croissance 1 comprenant sur un support de croissance 2 muni d'une couche d'assemblage en oxyde de silicium 3. Le support de croissance peut par exemple être constitué d'une plaquette de saphir de 150 mm de diamètre. Le substrat de croissance comporte trois groupes d'îlots 3a, 3b, 3c d'InGaN comportant 8% d'indium. Les îlots 3a, 3b, 3c présentent tous une épaisseur de 200 nm et une forme carrée de 50 microns de côté. Le premier groupe d'îlots 3a présente un paramètre de maille de 0,3190 nanomètre, le deuxième groupe présente un paramètre de maille de 0,3200 nanomètre et le troisième groupe présente un paramètre de maille de 0,3205 nm. Ces paramètres de maille cibles ont été choisis pour que l'étape de fabrication collective des couches actives de DELs conduise à la formation de DELs émettant des rayonnements dans le bleu, le vert et le rouge ou s'en approchant.

Les îlots 3 constituant chacun de ces groupes sont répartis et disposés sur le support de croissance 2 selon une disposition matricielle conforme à ce qui a été exposé en relation avec la description des figures 2a à 2c. Trois îlots 3, 3', et 3" de chacun des groupes sont donc disposés à proximité les uns des autres de manière à définir un pixel ; et ces regroupements d'îlots répartis matriciellement le long de lignes et de colonnes à la surface du substrat de croissance 1. On peut prévoir des tranchées de panneau 4' plus larges que les tranchées 4 séparant deux îlots pour séparer les matrices les unes des autres, chaque matrice délimitant un ensemble d'îlots 3, 3', 3" destiné à recevoir les DELs d'un micro panneau.

Pour fabriquer ce substrat de croissance 1 on prépare tout d'abord un substrat de relaxation 6 comprenant un support de relaxation 7, par exemple en saphir également de 150 mm, et d'une couche de fluage composé de BPSG. Le substrat de relaxation comprend également des îlots contraints 9 d'InGaN comportant 8% d'indium. Ces îlots contraints 9 sont disposés similairement à ce qui vient d'être décrit pour les îlots relaxés 3 du substrat de croissance 1. Le paramètre de même des îlots contraints 9 est de 0,3185 nanomètre.

Les îlots contraints 9 sont recouverts d'une couche raidisseur initiale 10' de GaN de 50 nm d'épaisseur, résidu d'une couche tampon de GaN d'un substrat donneur ayant servi à la réalisation du substrat de relaxation. On procède à un traitement thermique de relaxation par exemple à 800°C pendant une heure. Ce traitement conduit à la relaxation des îlots initialement contraint 9, pour former des îlots partiellement relaxés 3 qui présentent à l'issue du traitement thermique de relaxation un paramètre de maille de proche de 0,3190 nanomètre. Si ce n'est pas le cas, on peut renouveler l'application du traitement thermique de relaxation, éventuellement en amincissant la couche raidisseur initiale pour favoriser la relaxation des îlots 3.

On élimine ensuite par gravure uniquement la couche raidisseurs 10' qui recouvre les îlots 3 du deuxième et du troisième groupe, et on renouvelle le traitement thermique de relaxation. On peut également prévoir d'amincir les îlots 3 du deuxième et troisième groupe, par exemple de 40nm, pour favoriser leur relaxation. A l'issue de traitement, le paramètre de maille des îlots du premier groupe, recouvert par la couche de raidisseur 10 a assez peu varié, proche de 0,3190 nm. Par contre, le paramètre de maille des îlots du deuxième et du troisième groupe s'est agrandi pour être proche de 0,3200 nm.

Dans une étape suivante, on aminci uniquement les îlots du troisième groupe, par exemple de 70nm et on applique à nouveau le traitement thermique de relaxation. Les paramètres de maille des îlots du premier et second groupe restent relativement constants, et sont en tout cas moins affectés par ce traitement thermique que le paramètre de maille des îlots du troisième groupe qui est alors proche de 0,3205 nm.

On peut renouveler ce traitement thermique de relaxation final, éventuellement en combinaison avec un amincissement de la couche raidisseur disposé sur les îlots du premier groupe ou un amincissement des îlots du deuxième et second groupe, pour faire converger les paramètres de maille de ces îlots vers leurs paramètres de maille cible.

En tout état de cause, la répétition de ces étapes conduit à la relaxation sélective des groupes d'îlots et, à l'issue de ces étapes, le premier groupe d'îlots 3a présente un paramètre de maille de, ou proche de 0,3190 nanomètre, le deuxième groupe présente un paramètre de maille de, ou proche de, 3,200 nanomètres et le troisième groupe présente un paramètre de maille de, ou proche de 3,205 nm.

Les îlots 3 partiellement relaxés d'InGaN sont ensuite reportés par collage sur un support de croissance 2 munie d'une couche d'assemblage 5, par exemple un multicouche de dioxyde de silicium et de nitrure.

On place ensuite celui-ci dans une chambre d'un bâti d'épitaxie, dans lequel on fait circuler un ensemble de gaz précurseurs (TMGa, TEGa, TMIn, NH3) de manière à faire croître sur chacun des îlots des couches actives de DELs à base de nitrures.

Les paramètres de maille des îlots du premier groupe, du deuxième groupe et du troisième groupe d'îlots étant différents les uns des autres, l'incorporation d'indium dans les couches actives d'InGaN qui se forment sur les îlots de ces groupes est également différente. Sur les îlots du premier groupe, on obtient des DELs émettant directement un rayonnement dans le domaine du bleu, sur les îlots du deuxième groupe des DELs émettant directement un rayonnement dans le domaine du vert, et sur les îlots du troisième groupe on forme des DELs émettant directement un rayonnement dans le domaine du rouge.

À l'issue de cette étape de dépôt, on dispose donc, sur le substrat de croissance 1, de couche active de DELs disposés au niveau d'un pixel et émettant des couleurs dans le domaine du rouge, du vert, et du bleu.

On peut compléter la fabrication d'une DEL fonctionnelle sur le substrat de croissance, notamment en formant les contacts de DEL de part et d'autre des couches actives.

Si l'on souhaite disposer à ce stade de micro panneaux monolithiques, on peut découper la plaquette sur laquelle reposent les DELs qui viennent d'être formées selon les tranchées 4' définissant les matrices de pixels. Chacune de ces matrices constituant alors un micro panneau.

Alternativement, on peut également assembler la plaquette comprenant les micro panneaux à une seconde plaquette sur laquelle ont été formés des circuits de pilotage constitués d'une matrice de circuits d'attaque. Chaque matrice est disposée à la surface de cette plaquette selon la même disposition que les DELs sur le substrat de croissance. L'assemblage permet de mettre en contact électrique chaque diode à un circuit d'attaque. On constitue en une seule étape de mise en contact, une pluralité d'écran d'affichage. On peut ensuite choisir d'éliminer le support de croissance 2 par exemple par irradiation laser, et la couche d'assemblage 5, par exemple par gravure chimique, de manière à exposer une surface d'émission lumineuse des DELs. Ces surfaces peuvent être préparées à l'aide d'éléments optiques, de traitement ou de protection de surface afin d'améliorer la qualité et la robustesse de l'écran. La plaquette peut être découpée de manière conventionnelle de manière à isoler les écrans les uns des autres en vue de leur conditionnement.

### Deuxième exemple

On prépare un substrat donneur 11 constitué d'un substrat de saphir de 150 mm de diamètre et d'un empilement de couches élémentaires présentant les caractéristiques suivantes :
- une première couche de nitrure de gallium tampon présentant 2 microns d'épaisseur et dont la partie supérieure est essentiellement relaxée ;
- une deuxième couche élémentaire contrainte d'InGaN comprenant 8 % d'indium et de 200 nm d'épaisseur ;
- une troisième couche élémentaire contrainte d'InGaN comprenant 16 % en teneur d'indium et de 40 nm d'épaisseur.

Entre la deuxième et troisième couche, on peut prévoir une couche intermédiaire d'AlGaN comprenant entre 0% et 10% d'aluminium et d'épaisseur comprise entre 1 et 3 nm. Cette couche intermédiaire permet d'assurer que l'empilement 12, notamment la troisième couche élémentaire, soit bien pseudomorphique c'est-à-dire que toutes les couches élémentaires présentent toutes le même paramètre de maille. La concentration d'indium d'une couche à l'autre étant croissante, le niveau de contraintes de chaque couche est également croissant.

Par gravure locale, que l'on peut réaliser de manière traditionnelle par masquage photolithographique et gravure sèche, on expose au niveau de trois zones du substrat donneur la première, la deuxième, et la troisième couche élémentaire. Chaque zone est respectivement répartie à la surface du substrat donneur 11 selon la répartition en pixel et matricielle présentée en relation avec les figures 2a à 2c.

Après la définition des zones, on prépare une couche de collage 15 de 500 nm d'épaisseur comprenant du dioxyde de silicium et du bore et du phosphore en proportion massique de 4 %. La couche de collage est polie pour permettre son assemblage à un support de croissance 7 en saphir. On opère ensuite le transfert de l'empilement 12 des couches élémentaires sur un support de relaxation 7 en saphir, également de 150mm de diamètre, par exemple selon la technique d'implantation facture détaillée dans la description générale du procédé. Le substrat de saphir 7 a été préalablement muni d'une couche de fluage 8 en BPSG, c'est-à-dire comprenant du dioxyde de silicium et du bore et du phosphore, ici en proportion massique de 4 % en phosphore et de 6% en bore.

Après le transfert de l'empilement 12 sur la couche de fluage 8 du substrat de relaxation 7 en saphir, on délimite trois groupes d'îlots contraints 9, en réalisant des tranchées 4, les îlots 9a du primer groupe d'îlots sont définis dans la première zone 13a, les îlots 9b du deuxième groupe sont définis dans la deuxième zone et les îlots du troisième groupe sont définis dans une troisième zone de l'empilement. Les îlots 9a, 9b sont ici tous carrés et présentent un côté de 10 microns. Les îlots 9 du premier groupe sont constitués d'une unique couche de GaN, la première couche élémentaire qui est essentiellement relaxée. Les îlots 9 du deuxième groupe sont constitués d'un empilement formé d'une couche de GaN et d'une couche d'InGaN comprenant 6% d'indium, la deuxième couche élémentaire contrainte. Les îlots du troisième groupe sont constitués d'un empilement formé d'une couche de GaN, d'une couche d'InGaN comprenant 8% d'indium (la deuxième couche élémentaire) et d'une couche d'InGaN comprenant 16% d'indium (la troisième couche élémentaire).

Puis, on effectue un premier traitement thermique de relaxation visant à faire fluer la couche de fluage 8 et la couche de collage 15 et à libérer les contraintes des îlots. Dans cet exemple, l'étape s'effectue à 800°C pendant 4h.

Les îlots 9 du premier groupe d'îlots n'étant pas contraints, leur paramètre de maille n'évolue donc pas au cours de ce traitement thermique. Les îlots du deuxième et du troisième groupe sont composés d'un empilement de couches ayant des niveaux de contraintes différents. Le paramètre de maille de ces îlots tend vers le paramètre de maille d'équilibre de l'empilement de couches qui les constitue. Le paramètre obtenu sera proche du paramètre de maille de l'alliage (In,Ga)N de composition moyenne sur l'épaisseur de l'empilement.

Dans une étape suivante, les îlots sont partiellement gravés pour les amincir. L'épaisseur gravée est typiquement de l'ordre de 100nm. L'épaisseur des îlots est alors d'environ 50 à 60nm. Le fluage de la couche de fluage 8 et de la couche de collage 15 est de nouveau provoqué par application d'un nouveau traitement thermique de relaxation pour relâcher les contraintes résiduelles des îlots du deuxième et du troisième groupe. Ici, les conditions du deuxième traitement thermique sont identiques aux conditions du premier.

On peut renouveler le traitement thermique de relaxation, éventuellement en combinaison avec un amincissement des îlots, pour faire converger leurs paramètres de maille vers leurs paramètres de maille cible.

En tout état de cause, la répétition de ces étapes conduit à la relaxation différenciée des groupes d'îlots et, à l'issue de ces étapes, le premier groupe d'îlots 3a présente un paramètre de maille typiquement compris entre 3,180 A et 3,190 A, le deuxième groupe présente un paramètre de maille compris entre 3,210 A et 3,225 A et le troisième groupe présente un paramètre de maille compris entre 3,240 A et 3,255 A.

Les îlots 3 relaxés ou partiellement relaxés sont ensuite reportés par collage sur un support de croissance 2 munie d'une couche d'assemblage 5, par exemple un multicouche de dioxyde de silicium et de nitrure. On forme de la sorte un substrat de croissance 1. On peut poursuivre ce procédé similairement à celui de l'exemple 1, en faisant croître sur chacun des îlots des couches actives de DELs à base de nitrures et en complétant la fabrication de DELs fonctionnelles sur le substrat de croissance, notamment en formant les contacts de DEL de part et d'autre des couches actives, ou sous la forme d'un panneau monolithique.

### Troisième exemple

On prépare en premier lieu un substrat de croissance 1 comprenant sur un support de croissance 2 muni d'une couche d'assemblage 5 composée d'un empilement de 500nm d'oxyde de silicium en contact avec le support de saphir, 200nm de nitrure de silicium, et d'un micron de dioxyde de silicium. Cet empilement est conçu pour permettre le détachement par irradiation laser du support de croissance dans une étape ultérieure du procédé. Ce support de croissance peut par exemple être constitué d'une plaquette de saphir de 150 mm de diamètre. Le substrat de croissance comporte trois groupes d'îlots d'InGaN comportant 18% d'indium. Les îlots présentent tous une épaisseur de 40 nm et une forme carrée de 10 microns de côté. Le premier groupe d'îlots présente un paramètre de maille de 0,3184 nanomètre, le deuxième groupe présente un paramètre de maille de 0,3218 nanomètre et le troisième groupe présente un paramètre de maille de 0,3248 nm. Ces paramètres de maille cibles ont été choisis pour que l'étape de fabrication collective des couches actives de DELs conduise à la formation de DELs émettant des rayonnements dans le bleu, le vert et le rouge.

Les îlots 3 constituant chacun de ces groupes sont répartis et disposés sur le support de croissance 2 selon une disposition matricielle conforme à ce qui a été exposé en relation avec la description des figures 2a à 2c et des deux exemples précédents.

Pour fabriquer ce substrat de croissance 1 on prépare tout d'abord un substrat de relaxation 6 comprenant un support de relaxation 7, par exemple en saphir également de 150 mm, pour y former une couche de fluage 8.

La préparation de la couche de fluage comprend tout d'abord la formation d'une couche de démontage composée d'un empilement de 500nm d'oxyde de silicium en contact avec le support de saphir et de 200nm de nitrure de silicium. Cet empilement de démontage est conçu pour permettre le détachement par irradiation laser du support de relaxation 7 dans une étape ultérieure du procédé. On forme ensuite sur la couche de démontage, une première couche d'un micron de dioxyde de silicium. Par masquage lithographique et gravure, on forme dans la première couche des évidements disposés à la surface du support pour être en correspondance avec les îlots du deuxième groupe et ramenant l'épaisseur de la première couche de dioxyde de silicium à 100nm. On dépose ensuite à la surface du substrat, sur la première couche et les évidements, une deuxième couche d'environ un micron d'épaisseur, cette deuxième couche étant constituée de dioxyde de silicium et d'une proportion massique de 3% de Bore et 4% de Phosphore. On répète des étapes de masquage par photolithographie et gravure pour former de nouveaux évidements disposés cette fois à la surface du substrat pour être mis en correspondance avec les îlots du troisième groupe. La gravure est menée pour procéder au retrait de toute l'épaisseur de la deuxième couche en BPSG et préserver une épaisseur de 100nm de la première couche en dioxyde de silicium. On dépose ensuite une troisième couche constituée de dioxyde de silicium et d'une proportion massique de 4% de Bore et 4% de Phosphore. Enfin, on planarise la surface pour éliminer en partie les troisième et deuxième couches de manière à former le premier, deuxième et troisième groupe de pavés constituant la couche de fluage 8.

Le substrat de relaxation comprend également des îlots contraints 9 d'InGaN carré de 10 microns de côté comportant 18% d'indium reporté sur la couche de fluage 8 selon un procédé de transfert de couche détaillé dans la description générale, et par la réalisation de tranchés 4. Ces îlots contraints 9 sont disposés similairement à ce qui vient d'être décrit pour les îlots relaxés 3 du substrat de croissance 1. Le paramètre de maille des îlots contraints 9 est de 0,3184 nanomètre. Chaque îlot contraint 9 repose sur un pavé d'un des premier, deuxième et troisième groupe, définissant ainsi un premier, un deuxième et un troisième groupe d'îlot contraints.

Les îlots contraints 9 sont recouverts d'une couche raidisseur initiale de GaN de 50 nm d'épaisseur, résidu d'une couche tampon de GaN d'un substrat donneur ayant servi à la réalisation du substrat de relaxation.

On procède à un traitement thermique de relaxation par exemple à 750°C pendant une heure. Ce traitement conduit à l'expansion latérale des îlots initialement contraint 9, pour former des îlots partiellement relaxés 3. A la température de relaxation de 750°C, la viscosité des pavés du troisième groupe est estimée à 1E10 N.m⁻².s⁻¹ environ, celle des pavés du deuxième groupe est estimée à 4E10 N.m⁻².s⁻¹ environ, et celle des pavés du premier groupe, en dioxyde de silicium, n'est pas visqueux c'est-à-dire qu'il présente une viscosité supérieure à 1E12 N.m⁻².s⁻¹. En conséquence, à l'issue du traitement thermique de relaxation à 750°C, le taux de relaxation des contraintes dans les îlots du troisième groupe est de 90%, ils présentent donc un paramètre de maille de 3,246 Å. Le taux de relaxation des contraintes dans les îlots du deuxième groupe est d'environ 50%, soit un paramètre de maille de 3,218 Å. Le paramètre de maille des îlots du premier groupe n'a pas varié et reste à 3,184 Å.

Les valeurs de viscosités estimées sont données à titre d'exemple uniquement. Pour des pavés de compositions différentes ou pour une température de relaxation différente, le temps du traitement thermique peut être ajusté afin que le taux de relaxation de l'îlot disposé sur le pavé de viscosité intermédiaire soit à l'issue du procédé compris entre 40 et 60%, et que le taux de relaxation d'un îlot disposé sur un pavé de plus faible viscosité soit supérieur à 70%.

On élimine ensuite par gravure uniquement la couche raidisseurs de GaN qui recouvre les îlots partiellement relaxés, et on renouvelle le traitement thermique de relaxation dans les mêmes conditions que celles exposées précédemment. A l'issue de ce traitement, les paramètres de maille des îlots du premier, deuxième et troisième groupe sont respectivement de 3,184Â, 3,218Â et 3,248Â environ, c'est à dire à 0,005Å près.

Les îlots 3 partiellement relaxés d'InGaN sont ensuite reportés par collage sur un support de croissance 2 munie d'une couche d'assemblage 5, par exemple un multicouche de dioxyde de silicium et de nitrure. On peut poursuivre ce procédé similairement à celui de l'exemple 1 ou de l'exemple 2, en faisant croître sur chacun des îlots des couches actives de DELs à base de nitrures et en complétant la fabrication de DELs fonctionnelles sur le substrat de croissance, notamment en formant les contacts de DEL de part et d'autre des couches actives, ou sous la forme d'un panneau monolithique.

Bien entendu l'invention n'est pas limitée aux modes de mise en oeuvre décrits et on peut y apporter des variantes de réalisation sans sortir du cadre de l'invention tel que défini par les revendications.

## Revendications

1. Procédé d'utilisation d'un substrat de croissance (1) comprenant un support de croissance (2), une couche d'assemblage (5) et, disposée sur la couche d'assemblage (5), un premier groupe d'îlots semi-conducteurs cristallins (3a) présentant un premier paramètre de maille et un deuxième groupe d'îlots semi-conducteurs cristallins (3b) présentant un deuxième paramètre de maille, différent du premier pour fabriquer collectivement une pluralité de dispositifs optoélectroniques comportant des couches actives de compositions différentes, le procédé comprenant les étapes suivantes:
- fournir le substrat de croissance (1);
- exposer le substrat de croissance (1) à une atmosphère comprenant une concentration initiale d'un élément atomique pour former sur les îlots du premier groupe (3a) une première couche active incorporant l'élément atomique dans une première concentration et pour former sur les îlots du deuxième groupe (3b) une deuxième couche active incorporant l'élément atomique dans une deuxième concentration différente de la première.

2. Procédé d'utilisation selon la revendication précédente, dans lequel l'atmosphère est formée à partir de gaz précurseurs comprenant du TMGa, du TEGa, du TMIn et de l'ammoniaque.

3. Procédé d'utilisation selon la revendication précédente dans lequel l'élément atomique est de l'indium.

4. Procédé d'utilisation selon la revendication précédente dans lequel la première et la deuxième couche active comprennent une couche d' InGaN dopée n, un puits quantique multiple, une couche d' InGaN ou de GaN dopée p.

## Patentansprüche

1. Verfahren zur Verwendung eines Wachstumssubstrats (1), umfassend einen Wachstumsträger (2), eine Verbindungsschicht (5) und, auf der Verbindungsschicht (5) angeordnet, eine erste Gruppe von kristallinen halbleitenden Inseln (3a), die einen ersten Gitterparameter vorweisen, und eine zweite Gruppe von kristallinen halbleitenden Inseln (3b), die einen zweiten Gitterparameter vorweisen, der sich von dem ersten unterscheidet, um kollektiv eine Vielzahl von optoelektronischen Vorrichtungen, die aktive Schichten mit unterschiedlichen Zusammensetzungen aufweisen, herzustellen, das Verfahren umfassend die folgenden Schritte:
- Bereitstellen des Wachstumssubstrats(1);
- Aussetzen des Wachstumssubstrats (1) gegenüber einer Atmosphäre, umfassend eine Anfangskonzentration eines atomaren Elements, um auf den Inseln der ersten Gruppe (3a) eine erste aktive Schicht zu bilden, die das atomare Element in einer ersten Konzentration beinhaltet, und um auf den Inseln der zweiten Gruppe (3b) eine zweite aktive Schicht zu bilden, die das atomare Element in einer zweiten Konzentration beinhaltet, die sich von der ersten Konzentration unterscheidet.

2. Verfahren zur Verwendung nach dem vorstehenden Anspruch, wobei die Atmosphäre aus Vorläufergasen, umfassend TMGa, TEGa, TMIn und Ammoniak, gebildet wird.

3. Verfahren zur Verwendung nach dem vorstehenden Anspruch, wobei das atomare Element Indium ist.

4. Verfahren zur Verwendung nach dem vorstehenden Anspruch, wobei die erste und die zweite aktive Schicht eine n-dotierte InGaN-Schicht, eine Mehrfachquantensenke, eine p-dotierte InGaN- oder GaN-Schicht umfassen.

## Claims

1. A method for using a growth substrate (1) comprising a growth medium (2), an assembly layer (5) and, arranged on the assembly layer (5), a first group of crystalline semi-conductor islands (3a) having a first lattice parameter and a second group of crystalline semi-conductor islands (3b) having a second lattice parameter different from the first lattice parameter, in order to collectively manufacture a plurality of optoelectronic devices comprising active layers of different compositions, the method comprising the following steps:
- providing the growth substrate (1);
- exposing the growth substrate (1) to an atmosphere comprising an initial concentration of an atomic element in order to form, on the islands of the first group (3a), a first active layer incorporating the atomic element in a first concentration and to form, on the islands of the second group (3b), a second active layer incorporating the atomic element in a second concentration different from the first concentration.

2. The use method according to the preceding claim, wherein the atmosphere is formed from precursor gases comprising TMGa, TEGa, TMIn and ammonia.

3. The use method according to the preceding claim, wherein the atomic element is indium.

4. The use method according to the preceding claim, wherein the first and the second active layer comprise an n-doped InGaN layer, a multiple quantum well, and a p-doped InGaN or GaN layer.
